Europäisches Patentamt

European Patent Office

Office européen des brevets

(19)

(11) Veröffentlichungsnummer: **0 157 451 B1**

(12) # EUROPÄISCHE PATENTSCHRIFT

(45) Veröffentlichungstag der Patentschrift: **29.05.91**

(51) Int. Cl.⁵: **H05K 13/00**

(21) Anmeldenummer: **85200404.3**

(22) Anmeldetag: **18.03.85**

---

(54) **Produktträger für Leiterplatten.**

---

(30) Priorität: **20.03.84 DE 3410130**

(43) Veröffentlichungstag der Anmeldung:
**09.10.85 Patentblatt 85/41**

(45) Bekanntmachung des Hinweises auf die
Patenterteilung:
**29.05.91 Patentblatt 91/22**

(84) Benannte Vertragsstaaten:
**AT BE DE FR GB IT NL**

(56) Entgegenhaltungen:
**DE-A- 2 915 366**

(73) Patentinhaber: **Philips Patentverwaltung
GmbH
Wendenstrasse 35 Postfach 10 51 49
W-2000 Hamburg 1(DE)DE**

Patentinhaber: **N.V. Philips' Gloeilampenfabrieken
Groenewoudseweg 1
NL-5621 BA Eindhoven(NL)BE FR GB IT NL
AT**

(72) Erfinder: **Gumbert, Hans
Ballersbacherweg 30
W-6349 Sinn 1(DE)**

(74) Vertreter: **Kupfermann, Fritz-Joachim,
Dipl.-Ing. et al
Philips Patentverwaltung GmbH Wendenstrasse 35 Postfach 10 51 49
W-2000 Hamburg 1(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Erfindung bezieht sich auf einen Produktträger für Leiterplatten, die auf ihm einer Bearbeitung, insbesondere einer Bestückung mit Bauelementen zugeführt werden, wobei die Schaltungsplatten mit Richtlöchern versehen sind, in die Richtstifte eingreifen.

Auf den Produktträger aufgesetzte Leiterplatten werden von den Richtstiften oberhalb der Grundplatte in einer Bearbeitungsebene festgelegt. Die Produktträger werden auf Transportvorrichtungen gesetzt und fahren mit den auf ihnen aufliegenden Leiterplatten in verschiedene Bearbeitungspositionen. Aus der DE-OS 29 15 366 ist es bekannt, die Bichtstifte an einem Bestückungswerkzeug vorzusehen. Die von einer Transportvorrichtung in die Bearbeitungsposition gefahrene Leiterplatte wird in der Bearbeitungsposition ausgerichtet, indem Richtstifte in Richtlöcher der Leiterplatte eindringen. Diese Bearbeitungsmethode ist relativ ungenau, da für ein einwandfreies Bestücken Toleranzen zwischen den Richtlöchern der Leiterplatte und den Richtstiften unzulässig sind. Ein Ausrichten der Leiterplatten mit Hilfe von Richtstiften, die in der Bearbeitungsposition in diese einfahren, verlangt für einen störungsfreien Betrieb die Zulassung gewisser Toleranzen.

Günstiger sind deshalb Produktträger mit Grundplatte und Richtstiften an ihr, da so außerhalb der Bearbeitungsposition ein toleranzfreies und sicheres Aufsetzen der Leiterplatten möglich ist.

Wenn der Produktträger beispielsweise für das Chip-Bestücken von Leiterplatten eingesetzt wird, dann zeigt es sich, daß infolge der hohen Arbeitsleistung von Chip-Bestückungsmaschinen relativ häufig ein Wechsel der Leiterplattentypen notwendig ist. Der Wechsel eines Leiterplattentyps macht es aber notwendig, auch die Richtstifte anders zu plazieren. Dies kann durch ein Umschrauben erfolgen. Ein Umschrauben ist aber zeitaufwendig, und die Flexibilität hinsichtlich des Versetzens der Richtstifte ist begrenzt. Hinzu kommt noch, daß die Leiterplatten beim Bestücken möglicherweise zu sehr auf Biegung beansprucht werden, wenn größere Leiterplatten nur an den Ecken abgestützt sind.

Es ist Aufgabe der Erfindung, einen Produktträger zu schaffen, der ohne großen technischen Aufwand kurzfristig und mit wenigen Handgriffen umrüstbar ist für einen anderen Schaltungsplattentyp.

Die gestellte Aufgabe ist erfindungsgemäß dadurch gelöst, die Richtstifte au einer Grundplatte des Trägers setzbar sind, um die Leiterplatte auf dem Produktträger in einer bestimmten Stellung und Höhe zur Grundplatte festzulegen und daß die Richtstifte an der Grundplatte einzeln absenkbar angeordnet und zwischen den absenkbaren Richtstiften Setzfelder für Stützstifte vorgesehen sind, innerhalb der die Stützstifte jeweils an Stellen setzbar sind, von denen aus deise Stützstifte an der unteren Bestüchungsseite der Leiterplatte gegebenenfalls zwischen vorhandenen Bauelementen hindurch von unten her zur Ergänzung einer Stützebene bis zur unteren Bestückungsseite hochreichen.

Die Richtstifte werden dabei so plaziert, daß sie immer am Rand der Leiterplatte in dort vorgesehene Richtlöcher eingreifen, wobei es genügt, daß die Leiterplatte mit zwei Richtstiften abgestützt wird. Die anderen Richtstifte, die nicht zu der Lochanordnung der Leiterplatte passen, werden einfach abgesenkt. Die weitere Unterstützung der Leiterplatte übernehmen die Stützstifte, die auf eine große Anzahl von Plazierungsstellen innerhalb der Setzfelder gesetzt werden können. Dadurch lassen sich genügend viele Abstützpunkte an genügend vielen Plazierungsstellen finden.

Die Setzfelder können verschiedenartig ausgestaltet sein. Nach einer vorteilhaften Ausgestaltung der Erfindung ist dazu vorgesehen, daß die Setzfelder von Bohrungen in der Grundplatte bestimmt sind, in die die Stützstifte einsetzbar sind. Die Bohrungen erstrecken sich dabei vorzugsweise in Form eines Lochrasters über die Grundplatte.

Wänrend des Betriebes kann es passieren, daß beispielsweise Bruchstückchen von Schaltungsplatten oder andere Verschmutzungen in die Bohrungen hineinfallen und diese dann mehr oder weniger verstopfen. Um dies zu vermeiden, ist nach einer weiteren Ausgestaltung der Erfindung vorgesehen, daß in den Bohrungen Fußstifte stecken, auf die die Stützstifte mit einer an ihrem Fuß vorgesehenen Steckhülse aufsteckbar sind. Auf diese Weise ist immer sichergestellt, daß die Oberkanten der Stützstifte genau in der Stützebene zu liegen kommen.

Nach einer weiteren Ausgestaltung der Erfindung ist vorgesehen, daß die Richtstifte in vertikalen Führungskanälen von Stützklötzen angeordnet sind, die auf der Grundplatte lösbar befestigt sind, und daß in Einstiche der Richtstifte quer zu den Führungskanälen Arretierstifte einsteckbar sind, die in die Einstiche in angehobener Stellung der Richtstifte eingreifen. Durch das Herausziehen und wieder Einstecken der Arretierstifte können also die Richtstifte in die Stützebene gebracht oder unter die Stützebene abgesenkt werden. Zur Bestimmung der Stützebene ist nach einer weiteren Ausgestaltung der Erfindung vorgesehen, daß die Richtstifte an dem Auflageende für die Leiterplatte mit einer Auflagefläche für diese Platte versehen sind, aus deren Mitte ein Richtansatz hervorsteht, der in ein Richtloch der Leiterplatte eingreift. Die Auflageflächen der Richtstifte liegen bei angehobenen Stiften in der Stützebene.

Die Erfindung wird anhand des in der Zeichnung dargestellten Ausführungsbeispieles näher erläutert. Es zeigen:

Fig. 1 einen für schnelle Umrüstung geeigneten Produktträger in Draufsicht,

Fig. 2 den Produktträger im Schnitt längs der Linie II-II nach Fig. 1 und

Fig. 3 einen Schnitt durch den Produktträger nach Fig. 1 längs der Linie III-III zur Erläuterung der Höheneinstellung der Richtstifte.

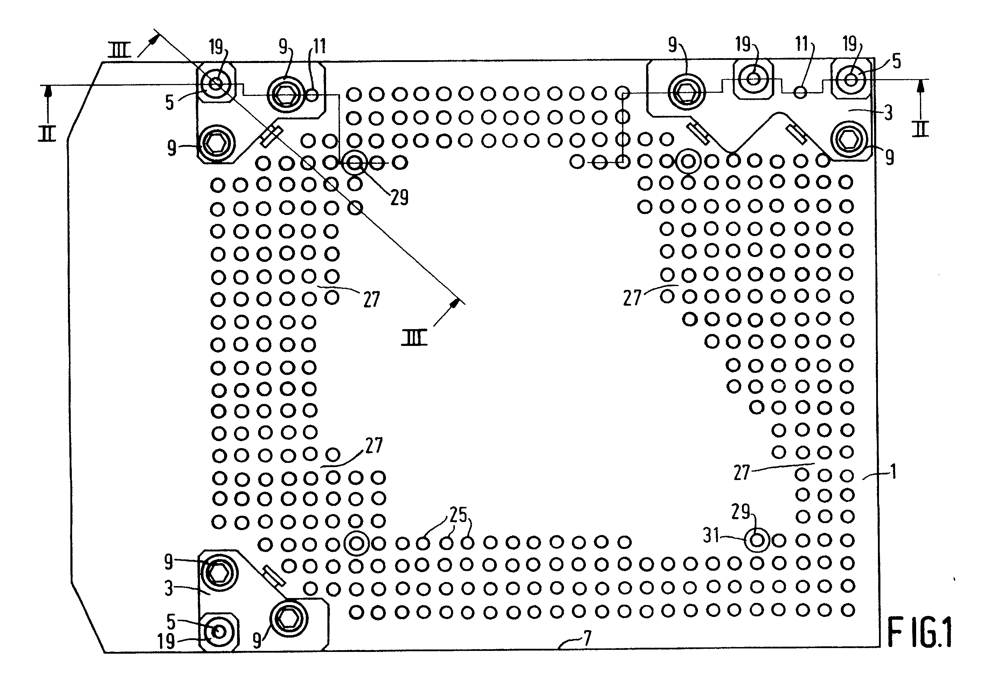

Der Produktträger nach Fig. 1 besteht aus einer Grundplatte 1, auf die Stützklötze 3 für Richtstifte 5 aufgeschraubt sind. Die Stützklötze 3 befinden sich am Rand 7 der Grundplatte. Bei dem Ausführungsbeispiel nach der Zeichnung sind drei Stützklötze 3 vorgesehen, von denen einer der Stützklötze mit zwei Richtstiften 5 versehen ist.

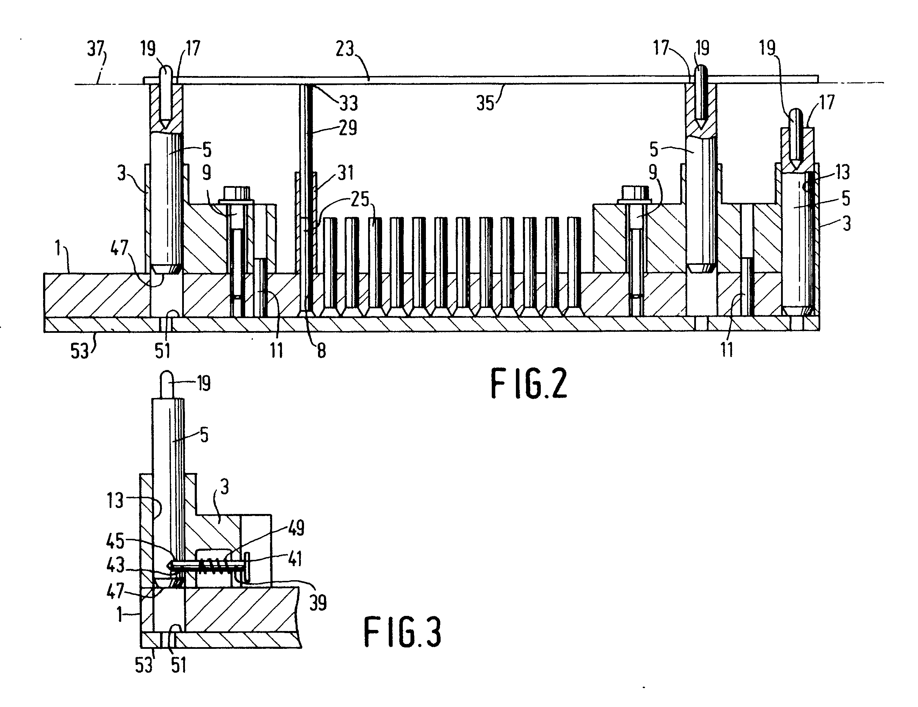

Zwischen den Stützklötzen 3 und damit auch zwischen den Richtstiften 5 sind Bohrungen vorgesehen, in die Stützstifte einsetzbar sind, die aus Fig. 2 zu ersehen sind. Die Bohrungen erstrecken sich nach Art eines Rasters im wesentlichen über die ganze Grundplatte bzw. deren von Stützklötzen freie Teile.

Fig. 2 zeigt die Grundplatte 1 im Schnitt II-II und aufgeschraubt auf die Grundplatte zwei Richtklötze 3. Das Festschrauben der Richtklötze 3 an der Grundplatte 1 erfolgt mit Hilfe von Schrauben 9. Die Ausrichtung der Stützklötze besorgen Verbindungsstifte 11, die von der Grundplatte 1 bis in die Richtklötze 3 reichen.

In den Richtklötzen sind vertikale Führungskanäle 13 vorgesehen, in denen die Richtstifte 5 auf und ab schiebbar sind. Die Richtstifte 5 sind an ihrem Auflageende mit einer Auflagefläche 17 versehen, aus deren Mitte jeweils ein Richtansatz 19 hervorsteht, der in ein Richtloch 21 einer Leiterplatte 23 eingreift.

In die Bohrungen 8 der Grundplatte sind Fußstifte 25 eingesetzt, und in allen Bohrungen 8 der Setzfelder 27 sitzen derartige Fußstifte 25. Auf die Fußstifte 25 können Stützstifte 29 aufgesetzt werden. Diese Stützstifte haben den Durchmesser der Fußstifte 25, und an ihrem Fußende sind sie mit einer Steckhülse 31 versehen, die auf den gewünschten Fußstift aufgesteckt werden kann. Das obere Ende 33 des Stützstiftes 29 kommt dabei genau an der Unterseite 35 der Leiterplatte 23 zu liegen. Die Auflageflächen 17 der hochgestellten Richtstifte 5 und die oberen Enden 33 der Stützstifte 25 fallen dabei in die Stützebene 37, auf der die Leiterplatte 23 plan aufliegt Es werden so viele Stützstifte 29 eingesetzt, wie nötig sind, um die Leiterplatte 23 zusätzlich zu der Abstützung in den Richtstiften 5 sicher zu unterstützen. Da eine große Variationsmöglichkeit in dem Setzen der Stützstifte 29 gegeben ist, können die Stützstifte 29 bei bereits bestückter Unterseite 35 der Schaltungsplatte so plaziert werden, daß sie immer zwischen bereits vorhandenen konkreten Bauelementen gegen die Unterseite 35 der Leiterplatte stoßen.

Fig. 3 zeigt anhand des Schnittes III-III nach Fig. 1 die Höhenverstellmöglichkeit der Richtstifte 5. Durch den Stützklotz 3 erstreckt sich quer zu dem Führungskanal 13 ein Arretierstift 39 mit einem Griffknopf 41 und einer Spitze 43. Die Spitze 43 greift in einen Einstich 45 des Richtstiftes 5 ein, wenn der Richtstift 5 hochgezogen ist in die Unterstützungsposition. Mittels einer Feder 49 wird der Arretierstift 39 immer in Richtung auf den Führungskanal 13 gedrückt. In der Zeichnung nach Fig. 3 ist der Richtstift 5 in angehobener Stellung dargestellt. Das entspricht der Stellung in Fig. 2, in der der Richtstift 5 die Unterseite 35 der Schaltungsplatte berührt. Sitzt der Richtstift 5 mit seiner Bodenfläche 47 auf der Oberseite 51 einer unteren Abschlußplatte 53 auf, dann befindet sich der Richtstift 5 in der abgesenkten Stellung. Diese abgesenkte Stellung ist in Fig. 2 die Stellung, die der ganz rechts dargestellte Richtstift 5 einnimmt.

## Ansprüche

1. Produktträger für Leiterplatten, die auf ihm einer Bearbeitung, insbesondere einer Bestükkung mit Bauelementen zugeführt werden, wobei die Leiterplatten mit Richtlöchern versehen sind, in die Richtstifte eingreifen, dadurch gekennzeichnet, daß die Richtstifte an einer Grundplatte (1) des Trägers setzbar sind, um die Leiterplatte auf dem Produktträger in einer bestimmten Stellung und Höhe zur Grundplatte festzulegen, und daß die Richtstifte (5) an der Grundplatte (1) einzeln absenkbar angeordnet und zwischen den absenkbaren Bichtstiften (5) Setzfelder (27) für Stützstifte (29) vorgesehen sind, innerhalb der die Stützstifte (29) jeweils an Stellen setzbar sind, von denen aus diese Stützstifte (29) an der unteren Bestückungsseite (35) der Leiterplatte gegebenenfalls zwischen vorhandenen Bauelementen hindurch von unten her zur Ergänzung einer Stützebene (37) bis zur unteren Bestückungsseite (35) hochreichen.

2. Produktträger nach Anspruch 1, dadurch gekennzeichnet, daß die Setzfelder (27) von Bohrungen (8) in der Grundplatte (1) bestimmt sind, in die die Stützstifte (29) einsetzbar sind.

3. Produktträger nach den Ansprüchen 1 und 2, dadurch gekennzeichnet, daß sich die Bohrungen (8) in Form eines Lochrasters über die Grundplatte (1) erstrecken.

4. Produktträger nach einem oder mehreren der Ansprüche 1 bis 3, dadurch gekennzeichnet, daß in den Bohrungen (8) Fußstifte (25) stekken, auf die die Stützstifte (29) mit einer an ihrem Fuß vorgesehenen Steckhülse (31) aufsteckbar sind.

5. Produktträger nach einem oder mehreren der Ansprüche 1 bis 4, dadurch gekennzeichnet, daß die Richtstifte (5) in vertikalen Führungskanälen (13) von Stützklötzen (3) angeordnet sind, die auf der Grundplatte (1) lösbar befestigt sind, und daß in Einstiche (45) der Bichtstifte (39) quer zu den Führungskanälen (13) Arretierstifte (39) einsteckbar sind, die in die Einstiche in angehobener Stellung der Richtstifte eingreifen.

6. Produktträger nach den Ansprüchen 1 und 5, dadurch gekennzeichnet, daß die Richtstifte (5) an dem Auflageende für die Schaltungsplatte (23) mit einer Auflagefläche (17) für diese Platte (23) versehen sind, aus deren Mitte ein Richtansatz (19) hervorsteht, der in ein Richtloch (21) der Leiterplatte (23) eingreift.

## Claims

1. A product carrier for circuit boards, which on this carrier are transferred to an operation, more particularly to a component mounting operation, the circuit boards being provided with locating holes into which locating pins engage, characterized in that the locating pins can be set on a base plate (1) of the carrier in order to fix the circuit board on the product carrier in a given position and height relative to the base plate, and in that the locating pins (5) are arranged on the base plate (1) so that they can be individually lowered, while mounting areas (27) are provided between the lowerable locating pins (5) for supporting pins (29), within which areas (27) the supporting pins (29) can be arranged in position from which these supporting pins (29) extend vertically up to the lower side (35) of the circuit board, between components which may already be present at this lower side (35) of the circuit board, to additionally define a supporting plane (37).

2. A product carrier as claimed in Claim 1, characterized in that the mounting areas (27) are defined by bores (8) in the base plate (1), into which the supporting pins (29) can be inserted.

3. A product carrier as claimed in Claims 1 and 2, characterized in that the bores (8) extend in the form of a raster of holes over the base plate (1).

4. A product carrier as claimed in one or several of Claims 1 to 3, characterized in that foot pins (25) are inserted into the bores (8), the supporting pins (29) being mounted onto said foot pins by means of mounting sleeves (31) provided at their feet.

5. A product carrier as claimed in one or several of Claims 1 to 4, characterized in that the locating pins (5) are arranged in vertical guiding ducts (13) of supporting blocks (3), which are detachably secured on the base plate (1), and in that locking pins (39) can be inserted into recesses (45) of the locating pins (39) transverse to the guiding ducts (13), which locking pins engage into said recesses in the lifted position of the locating pins.

6. A product carrier as claimed in Claims 1 and 5, characterized in that the locating pins (5) are provided at their contact side with the circuit board (23) with a contact surface (17), from the centre of which projects a locating peg (19), which engages into a locating hole (21) of the circuit board (23).

## Revendications

1. Support porte-produit pour des plaques de circuit imprimé qui, sur ce support, sont soumises à une opération, notamment l'opération d'équipement en composants, les plaques de circuit imprimé présentant des trous de positionnement dans lesquels s'engagent des tiges de positionnement, caractérisé en ce que les tiges de positionnement peuvent être réglées à l'endroit d'une plaque de base (1) du support porte-produit pour fixer les plaques de circuit imprimé, placées sur le support porte-produit, dans une position et à une hauteur déterminées par rapport à la plaque de base, en ce que les tiges de positionnement (5) sont disposées sur la plaque de base (1) de façon à pouvoir être descendues séparément, et en ce qu'entre les tiges de positionnement (5) pouvant être descendues sont prévues des zones de pose (27) pour des tiges d'appui (29), zones de pose dans lesquelles les tiges d'appui (29) peuvent être posées dans des emplacements à partir desquels, du côté de la face inférieure d'équipement (35) de la plaque de circuit imprimé, ces tiges d'appui (29) s'étendent de bas en haut, en passant éventuellement entre des composants déjà montés, jusqu'à la face inférieure d'équipement (35) pour compléter un plan d'appui (37).

2. Support porte-produit selon la revendication 1, caractérisé en ce que les zones de pose (27) sont définies par des alésages (8) pratiqués dans la plaque de base (1) et dans lesquels peuvent être introduites les tiges d'appui (29).

3. Support porte-produit selon les revendications 1 et 2, caractérisé en ce que les alésages (8) s'étendent sur la plaque de base (1) sous la forme d'une configuration de trous.

4. Support porte-produit selon une ou plusieurs des revendications 1 à 3, caractérisé en ce que, dans les alésages (8), pénètrent des tiges de base (25) sur lesquelles peuvent être montées les tiges d'appui (29) par un manchon de montage (31) prévu à leur extrémité inférieure.

5. Support porte-produit selon une ou plusieurs des revendications 1 à 4, caractérisé en ce que les tiges de positionnement (5) sont disposées dans des canaux de guidage verticaux (13) de blocs d'appui (3) fixés de façon détachable sur la plaque de base (1), et en ce que, dans des trous (45) pratiqués dans les tiges de positionnement (5), peuvent être introduites, transversalement aux canaux de guidage (13), des tiges d'arrêt (39) qui s'engagent dans les trous dans la position supérieure des tiges de positionnement.

6. Support porte-produit selon l'une quelconque des revendications 1 et 5, caractérisé en ce que, à l'extrémité d'appui pour la plaque de circuit imprimé (23), les tiges de positionnement (5) présentent une surface d'appui (17) pour cette plaque (23), surface d'appui du centre de laquelle fait saillie un appendice de positionnement (19) s'engageant dans un trou de positionnement (21) de la plaque de circuit imprimé (23).

FIG.1

FIG.2

FIG.3

EP 0 157 451 B1